# EUROPEAN PATENT APPLICATION

(11) **EP 1 479 793 A2**
(43) Date of publication of application: **24.11.2004**
(21) Application number: 04252619.4
(22) Date of filing: 05.05.2004
(51) Int. Cl.: C25D 7/12, C25D 3/38

(54) **Plating method**

(30) Priority: 23.05.2003 US 472840 P; 07.07.2003 US 485318 P
(71) Applicant: Rohm and Haas Electronic Materials, L.L.C., Marlborough, Massachusetts 01752 (US)
(72) Inventor: Wang, Deyan, Hudson Massachusetts 01749 (US); Mikkola, Robert D., Grafton Massachusetts 01536 (US)
(74) Representative: Kent, Venetia Katherine

(57) **Abstract**

Compositions suitable for electroplating copper including one or more sources of copper, one or more alkanolamines or polymeric amines; and water are provided. These compositions are useful in the deposition and repair of seed layers used in the manufacture of electronic devices. Methods using these compositions are also provided.

## Description

### Background of the Invention

This invention relates generally to the field of electroplating. In particular, the present invention relates to the field of electrodeposition of copper on substrates.

The trend toward smaller microelectronic devices, such as those with sub-micron geometries, has resulted in devices with multiple metallization layers to handle the higher densities. One common metal used for forming metal lines, also referred to as wiring, on a semiconductor wafer is aluminum. Aluminum has the advantage of being relatively inexpensive, having low resistivity, and being relatively easy to etch. Aluminum has also been used to form interconnections in vias to connect the different metal layers. However, as the size of via/contact holes shrinks to the sub-micron region, a step coverage problem appears which in turn can cause reliability problems when using aluminum to form the interconnections between the different metal layers. Such poor step coverage results in high current density and enhances electromigration.

One approach to providing improved interconnection paths in the vias is to form completely filled plugs by using metals such as tungsten while using aluminum for the metal layers. However, tungsten processes are expensive and complicated, tungsten has high resistivity, and tungsten plugs are susceptible to voids and form poor interfaces with the wiring layers.

Copper has been proposed as a replacement material for interconnect metallizations in the manufacture of integrated circuits. Copper has the advantages of improved electrical properties as compared to tungsten and better electromigration property and lower resistivity than aluminum. The drawbacks to copper are that it is more difficult to etch as compared to aluminum and tungsten and it has a tendency to migrate into the dielectric layer, such as silicon dioxide. Such migration of copper leads to device failure. To prevent such migration, a barrier layer, is typically deposited on the dielectric layer prior to the depositing of a copper layer.

Typical vapor deposition techniques are used for applying a metal seed layer, such as physical vapor deposition ("PVD") and chemical vapor deposition ("CVD"). Typically, seed layers are thin in comparison to other metal layers, such as from 50 to 1500 angstroms thick. Such metal seed layers, particularly copper seed layers, may suffer from problems such as metal oxide both on the surface of the seed layer and in the bulk of the layer as well as discontinuities in the layer. Such discontinuities often arise from shortcomings of the vapor deposition techniques used.

Discontinuities or voids are areas in the seed layer where coverage of the metal, such as copper, is incomplete or lacking. Such discontinuities can arise from insufficient blanket deposition of the metal layer, such as depositing the metal in a line-of-sight fashion. In order for a complete metal layer to be electrochemically deposited on such a seed layer, the discontinuities must be filled in prior to or during the deposition of the final metal layer, or else voids in the final metal layer may occur.

U.S. Patent No. 6,197,181 (Chen) discloses a method of providing a seed layer by first vapor depositing an ultra-thin seed layer followed by electrochemically enhancing the ultra-thin seed layer using an alkaline copper plating bath to form a final seed layer. According to this patent application, such a two step process provides a seed layer having reduced discontinuities, i.e. areas in the seed layer where coverage of the seed layer is incomplete or lacking. The alkaline copper plating baths disclosed in this patent contain a complexing agent selected only from ethylene diamine tetraacetic acid, ethylene diamine or a polycarboxylic acid, with polycarboxylic acids being preferable. These copper plating baths do not always produce smooth and uniform copper deposits, particularly when used to deposit copper on a barrier layer. Seed layers that are not smooth and uniform may adversely affect subsequently deposited metal layers. Typically, a number of minutes is required to deposit or repair a copper seed layer on a barrier layer using the plating baths disclosed in this patent.

Electrochemical deposition is a desirable alternative method of depositing a seed layer. Such electrodeposited seed layers are expected to contain no or a reduced number of discontinuities as compared to vapor deposited seed layers. However, conventional copper electroplating baths have not been successful in depositing or repairing a copper layer on conventional barrier layers, which are often only semi-conductive. There is a need for copper electroplating baths capable of depositing a seed layer directly on a barrier layer. There is also a need for copper seed layer repair baths that provide smoother and more uniform deposits as compared to conventional seed layer repair baths.

### Summary of the Invention

The present invention provides a composition suitable for depositing a copper seed layer including one or more sources of copper ions; one or more amine-containing compounds chosen from alkanolamines, polymeric amines and mixtures thereof; and water, wherein the composition has a pH > 7. Such composition is typically free of a reducing agent for copper.

The present invention also provides a method of depositing a copper seed layer including the steps of contacting a substrate including a barrier layer with an electroplating bath including one or more sources of copper ion, one or more amine-containing compounds chosen from alkanolamines, polymeric amines and mixtures thereof, and water; and applying sufficient current density for a period of time to deposit a desired layer of copper. Typically, the substrate includes a barrier layer to reduce copper electromigration. Discontinuous seed layers may also be repaired by the steps of contacting the substrate with the an electroplating bath including one or more sources of copper ion, one or more amine-containing compounds chosen from alkanolamines, polymeric amines and mixtures thereof, and water and applying sufficient current density for a period of time to deposit a repair the discontinuities.

Further, a method of manufacturing an electronic device including the step of depositing a copper seed layer including the steps of contacting a substrate including a barrier layer with an electroplating bath including one or more sources of copper ion, one or more amine-containing compounds chosen from alkanolamines, polymeric amines and mixtures thereof, and water; and applying sufficient current density for a period of time to deposit a desired layer of copper is provided.

### Brief Description of the Drawing

Fig. 1 is an AFM of a layer of copper deposited on a tungsten barrier layer using a plating bath of the invention.
Fig. 2 is an AFM of a layer of copper deposited on a tungsten barrier layer using a conventional plating bath.
Fig. 3 is an AFM of a layer of copper deposited on a tungsten nitride barrier layer using a plating bath of the invention.
Fig. 4 is an AFM of a layer of copper deposited on a tungsten nitride barrier layer using a conventional plating bath.

### Detailed Description of the Invention

As used throughout this specification, the following abbreviations shall have the following meanings, unless the context clearly indicates otherwise: A = amperes; mA/cm² = milliamperes per square centimeter; ° C = degrees Centigrade; g = gram; Å = angstrom; L = liter, ppm = parts per million; M = molar; AFM = atomic force micrograph; µm = micron = micrometer; cm = centimeter; DI = deionized; cps = centipoise; sec. = seconds; and mL = milliliter. All amounts are percent by weight and all ratios are by weight, unless otherwise noted. All numerical ranges are inclusive and combinable in any order, except where it is clear that such numerical ranges are constrained to add up to 100%.

As used throughout the specification, "feature" refers to the geometries on a substrate, such as, but not limited to, trenches and vias. "Apertures" refer to recessed features, such as vias and trenches. The term "small features" refers to features that are one micron or smaller in size. "Very small features" refers to features that are one-half micron or smaller in size. Likewise, "small apertures" refer to apertures that are one micron or smaller (≤ 1 µm) in size and "very small apertures" refer to apertures that are one-half micron or smaller (≤ 0.5 µm) in size. As used throughout this specification, the term "plating" refers to metal electroplating, unless the context clearly indicates otherwise. "Deposition" and "plating" are used interchangeably throughout this specification. "Halide" refers to fluoride, chloride, bromide and iodide. Likewise, "halo" refers to fluoro, chloro, bromo and iodo. The term "alkyl" includes linear, branched and cyclic alkyl. "Brightener" refers to an organic additive that increases the plating rate of the electroplating bath. "Leveler" refers to an organic compound that is capable of providing a substantially planar metal layer. The terms "levelers" and "leveling agents" are used interchangeably throughout this specification. "(Meth)acrylate" refers to both methacrylate and acrylate. Likewise, "(meth)acrylamide" refers to both methacrylamide and acrylamide.

The present invention provides a composition including one or more sources of copper ions, one or more amine-containing compounds chosen from alkanolamines, polymeric amines and mixtures thereof; and water. Such composition is suitable for electroplating copper on a substrate, and particularly for depositing or repairing a copper seed layer on a substrate. Any substrate upon which a metal, particularly copper, can be electroplated is useful in the present invention. Such substrates include, but are not limited to, printed wiring boards, integrated circuits, semiconductor packages, lead frames, interconnects, and the like. Particularly useful substrates are any used in the manufacture of electronic devices, such as integrated circuits, and more particularly wafers used in dual damascene manufacturing processes. Such substrates typically contain a number of features, particularly apertures, having a variety of sizes. For example, integrated circuit substrates may contain apertures ranging from 100 µm to as little as 50 nm or 25 nm or less. In one embodiment, the substrate contains small apertures, and preferably very small apertures. Such small apertures may be present in the substrate along with larger apertures, such as 100 µm apertures. For example, an integrated circuit substrate may contain one or more 0.2 µm as well as one or more 2 µm, or even larger, apertures. It will be appreciated by those skilled in the art that other substrates to be plated, such as lead frames and printed wiring boards, may have larger features or smaller features or no features at all.

Typically, the substrate contains one or more of dielectric layers, barrier layers, cap layers or a combination of any of these layers. "Cap layers", as used herein, refer to layers such as hardmasks, etch stops, chemical-mechanical planarization ("CMP") stops, and any other layer used to seal a dielectric layer or otherwise provide an etch or removal differential. Exemplary dielectric layers include, but are not limited to, any insulating layer having a dielectric constant of ≤ 10. More exemplary dielectric layers have a dielectric constant of ≤ 4. In one embodiment, the dielectric layers are "low-k" dielectric layers used in the manufacture of integrated circuits. Such "low-k" dielectric layers typically have a dielectric constant of ≤ 3, ≤ 2.5 or even ≤ 2. Exemplary dielectric materials include, without limitation, inorganic materials such as organo polysilicas, carbides, oxides, nitrides and oxyfluorides of silicon, boron, or aluminum; and organic materials such as benzocyclobutenes, poly(aryl esters), poly(ether ketones), polycarbonates, poly(arylene ethers), polyaromatic hydrocarbons such as polynaphthalene, polyquinoxalines, poly(perfluorinated hydrocarbons) such as poly(tetrafluoroethylene), polyimides, polybenzoxazoles and polycycloolefins such as polynorbornenes. Suitable dielectric materials include the polyarylenes, polyarylene ethers and bezocyclobutenes disclosed in WO 00/31183 (Bruza et al.), and the polyimides disclosed in U.S. Patent Nos. 6,093,636 (Carter et al.) and 5,969,088 (Ezzell et al.). The dielectric materials may be deposited by a variety of techniques, such as by spin-on techniques and chemical vapor deposition techniques.

By "organic polysilica resin" is meant a compound including silicon, carbon, oxygen and hydrogen atoms. Suitable organo polysilica dielectric materials can comprise silsesquioxanes, partially condensed halosilanes or alkoxysilanes such as partially condensed by controlled hydrolysis tetraethoxysilane having number average molecular weight of about 500 to about 20,000, organically modified silicates having the composition RSiO₃ or R₂SiO₂ wherein R is an organic substituent, and partially condensed orthosilicates having Si(OR)₄ as the monomer unit. Silsesquioxanes are polymeric silicate materials of the type RSiO_{1.5} where R is an organic substituent. Particularly suitable organo polysilicas are composed of condensates or hydrolyzates of CH₃Si(Y)₃ where Y is a reactive group such as halogen, (C₁-C₆)alkoxy or acetoxy.

In one embodiment, exemplary organic polysilica resins are hydrolyzates and partial condensates of one or more silanes of formulae (I) or (II):

RₐSiY₄₋ₐ (I)

R¹ _{b}(R²O)_{3-b}Si(R³)_{c}Si(OR⁴)_{3-d}R⁵ _{d} (II)

wherein R is hydrogen, (C₁-C₈)alkyl, (C₇-C₁₂)arylalkyl, substituted (C₇-C₁₂)arylalkyl, aryl, and substituted aryl; Y is any hydrolyzable group; a is an integer of 0 to 2; R¹, R², R⁴ and R⁵ are independently selected from hydrogen, (C₁-C₆)alkyl, (C₇-C₁₂)arylalkyl, substituted (C₇-C₁₂)arylalkyl, aryl, and substituted aryl; R³ is selected from (C₁-C₁₀)alkyl, -(CH₂)ₕ-, -(CH₂)ₕ₁-Eₖ-(CH₂)ₕ₂-, -(CH₂)ₕ-Z, arylene, substituted arylene, and arylene ether; E is selected from oxygen, NR⁶ and Z; Z is selected from aryl and substituted aryl; R⁶ is selected from hydrogen, (C₁-C₆)alkyl, aryl and substituted aryl; b and d are each an integer of 0 to 2; c is an integer of 0 to 6; and h, h1, h2 and k are independently an integer from 1 to 6; provided that at least one of R, R¹, R³ and R⁵ is not hydrogen. "Substituted arylalkyl", "substituted aryl" and "substituted arylene" refer to an arylalkyl, aryl or arylene group having one or more of its hydrogens replaced by another substituent group, such as cyano, hydroxy, mercapto, halo, (C₁-C₆)alkyl, (C₁-C₆)alkoxy, and the like.

It is preferred that R is (C₁-C₄)alkyl, benzyl, hydroxybenzyl, phenethyl or phenyl, and more preferably methyl, ethyl, iso-butyl, tert-butyl or phenyl. Preferably, a is 1. Suitable hydrolyzable groups for Y include, but are not limited to, halo, (C₁-C₆)alkoxy, acyloxy and the like. Preferred hydrolyzable groups are chloro and (C₁-C₂)alkoxy. Suitable organosilanes of formula (I) include, but are not limited to, methyl trimethoxysilane, methyl triethoxysilane, phenyl trimethoxysilane, phenyl triethoxysilane, tolyl trimethoxysilane, tolyl triethoxysilane, propyl tripropoxysilane, iso-propyl triethoxysilane, iso-propyl tripropoxysilane, ethyl trimethoxysilane, ethyl triethoxysilane, iso-butyl triethoxysilane, iso-butyl trimethoxysilane, tert-butyl triethoxysilane, tert-butyl trimethoxysilane, cyclohexyl trimethoxysilane, cyclohexyl triethoxysilane, benzyl trimethoxysilane, benzyl triethoxysilane, phenethyl trimethoxysilane, hydroxybenzyl trimethoxysilane, hydroxyphenylethyl trimethoxysilane and hydroxyphenylethyl triethoxysilane.

The dielectric materials may be solid or porous. Porous dielectric materials are well known to those skilled in the art and may be prepared by a variety of methods, such as those disclosed in U.S. Patent No. 6,420,441 (Allen et al.).

Barrier layers, as used herein, refer to any layer that reduces and preferably prevents, the migration (or diffusion) of copper into the dielectric layer. Suitable barrier layers include, without limitation, those composed of one or more of tantalum, titanium, tungsten, cobalt, and any alloys of any one or more of the forgoing metals including nitrides and silicides thereof, silicon carbide and silicon nitride. Exemplary alloys include, without limitation, tantalum nitride, tantalum nitride silicide, titanium nitride, titanium nitride silicide, tungsten nitride and tungsten nitride silicide. More than one barrier layer may be used, such as titanium followed by titanium nitride and optionally followed by titanium nitride silicide. Such barrier layers may be discrete layers or they may be graduated, such as, for example, going from titanium on the bottom through a titanium sub-stoichiometric nitride to a titanium stoichiometric nitride upper layer.

The present invention is particularly suitable for depositing seed layers or repairing seed layers in apertures having a wide range of aspect ratios, such as low aspect ratio apertures and high aspect ratio apertures. By "low aspect ratio" is meant an aspect ratio of from 0.1:1 to 4:1. The term "high aspect ratio" refers to aspect ratios of 4:1 or greater such as 10:1 1 or 20:1. Thus, apertures having a wide variety of aspect ratios, such as 0.5:1, 1:1, 2:1, 2.5:1, 3:1, 4:1, 5:1, 6:1, 8:1, 10:1 or even higher, may be plated with copper according to the present invention. In one embodiment, the present compositions are useful for depositing or repairing one or more seed layers in both high and low-aspect ratio apertures on a substrate.

Any suitable source of copper ions may be used provided that it is at least partially soluble in water. Copper salts are particularly suitable sources of copper ions. A variety of copper salts may be used, including, but not limited to, copper sulfate, copper halide, copper carboxylates, copper alkanesulfonates, copper arylsulfonates, copper fluoroborate, and cupric nitrate. Exemplary copper carboxylates include, without limitation, copper acetate, copper gluconate, and copper citrate. Other exemplary sources of copper ions include, without limitation, copper chloride, copper methanesulfonate, copper ethanesulfonate, copper propanesulfonate, copper phenylsulfonate, and copper p-toluenesulfonate. It will be appreciated that mixtures of sources of copper ions may be used in the present invention. Copper sulfate pentahydrate is particularly suitable. Such copper salts are generally commercially available and may be used without further purification.

Copper is typically present in the plating bath in the form of copper ion in a concentration of 0.005 to 0.5 M. Exemplary concentrations of copper ion are from 0.01 to 0.3 M. Other exemplary concentration ranges of copper ion are from 0.02 to 0.3 M and from 0.03 to 0.25 M.

The present copper plating baths may also contain amounts of one or more other alloying metals, such as, but not limited to, tin, silver, zinc, and the like. Such alloying metals are typically added to the bath in the form of an at least partially water soluble salt. Exemplary metal salts include metal sulfate, metal sulfamate, metal halide, metal fluoroborate, metal acetate, metal gluconate, metal citrate, metal alkanesulfonate, metal arylsulfonate, and metal nitrate. Suitable copper alloys include, without limitation, copper-tin having up to 2 percent by weight tin, copper-silver, tin-copper-silver, and tin-copper-bismuth. The amounts of each of the sources of metal ions in such mixtures depends upon the particular alloy to be plated and is well known to those skilled in the art. In general, the amount of such alloying metal ion is up to 5% by weight of the total amount of metal ions in the composition. Such amounts are within the ability of those skilled in the art.

Thus, the present copper electroplating baths may deposit copper or copper alloy. In one embodiment, the present copper plating baths deposit copper and thus are free of additional metal to be deposited, i.e. they are not used to deposit a copper alloy. In such baths, copper is the only metal to be deposited.

The present metal electroplating baths include an electrolyte. The electrolyte may be either acidic or alkaline. When an acidic electrolyte is used, it is typically weakly acidic, such as having a pH of ≥ 6. Alkaline electrolytes provide a plating bath having a pH of > 7. Exemplary alkaline plating baths have a pH of 7.5 to 14. More exemplary plating baths have a pH in the range of 8 to 13. Other suitable pH ranges include, without limitation, 9 to 12, 9.5 to 12, and 10 to 12. The pH of the present plating baths may be adjusted by adding an appropriate amount of acid, base or both acid and base. Suitable acids include, but are not limited to, sulfuric acid, acetic acid, fluoroboric acid, alkylsulfonic acids such as methanesulfonic acid, ethanesulfonic acid, propanesulfonic acid and trifluoromethane sulfonic acid, arylsulfonic acids such as phenyl sulfonic acid, phenol sulfonic acid and toluenesulfonic acid, sulfamic acid, hydrochloric acid, and phosphoric acid. It will be appreciated by those skilled in the art that more than one acid may be used. Exemplary bases include metal carbonates, and hydroxide compounds including alkali metal hydroxides, alkaline earth hydroxides and metal-ion free base hydroxides such as sodium hydroxide, potassium hydroxide, ammonium hydroxide and tetramethylammonium hydroxide. It will be appreciated by those skilled in the art that more than one base may be used. Such electrolytes are generally commercially available from a variety of sources and may be used without further purification.

One or more amine-containing compounds chosen from alkanolamines, polymeric amines and mixtures thereof are used in the present electroplating baths. While not wishing to be bound by theory, it is believed that such amine-containing compounds function as complexing agents for copper. It is further believed that these amine-containing compounds also function as levelers to provide a smoother copper deposit as compared to conventional seed layer repair baths. Exemplary amine-containing compounds include, without limitation, polyethylenimines including alkoxylated polyethylenimines and polyethylenimine-epichlorohydrin products, polypropylenimines, amine-containing (meth)acrylate polymers such as those containing as polymerized units one or more monomers chosen from dialkylaminoalkyl (meth)acrylates and dialkylaminoalkyl (meth)acrylamides, and (meth)acrylamide polymers. The amine-containing (meth)acrylate monomers may be homopolymers of amine-containing (meth)acrylate monomers or copolymers containing one or more amine-containing (meth)acrylate monomers. (Meth)acrylamide polymers include homopolymers composed of (meth)acrylamide monomer as polymerized units or copolymers composed of one or more (meth)acrylamide monomers. The amine-containing (meth)acrylate copolymers as well as the (meth)acrylamide copolymers may optionally contain one ore more other ethylenically unsaturated monomers as polymerized units. Such amine-containing compounds are generally commercially available or may be prepared by methods known in the art. For example, amine-containing (meth)acrylate polymers and (meth)acrylamide polymers are available from the Rohm and Haas Company (Philadelphia, Pennsylvania). Such compounds may be used as is or may be further purified prior to use. The amine-containing compounds are typically water-soluble in the amount used.

Exemplary dialkylaminoalkyl (meth)acrylates and dialkylaminoalkyl (meth)acrylamides include, without limitation, dialkylamino(C₂-C₆)-alkyl (meth)acrylates and dialkylamino(C₂-C₆)alkyl (meth)acrylamides. Other examples of such substituted (meth)acrylates and (meth)acrylamides include, but are not limited to: dimethylaminoethyl methacrylate, dimethylaminoethyl acrylate, N,N-dimethylaminoethyl methacrylamide, N,N-dimethylaminopropyl methacrylamide, N,N-dimethylaminobutyl methacrylamide, N,N-diethylaminoethyl methacrylamide, N,N-diethylaminopropyl methacrylamide, N,N-diethylaminobutyl methacrylamide, N-(1,1-dimethyl-3-oxobutyl) acrylamide, N-(1,3-diphenyl-1-ethyl-3-oxobutyl) acrylamide, N-(1-methyl-1-phenyl-3-oxobutyl) methacrylamide, and 2-hydroxyethyl acrylamide, N-methacrylamide of aminoethyl ethylene urea, N-methacryloxy ethyl morpholine, N-maleimide of dimethylaminopropylamine and mixtures thereof.

Particularly useful amine-containing compounds include polyethylenimines. Certain polyethylenimines may contain primary, secondary and tertiary amines while other polyethylenimines contain only or primarily secondary amines and still others contain only or primarily tertiary amines. Alkoxylated polyethylenimines are typically prepared by the reaction of a polyethylenimine with an alkyleneoxide. For example, ethoxylated polyethylenimine is prepared by the reaction of a polyethylenimine with ethyleneoxide. Likewise, propoxylated polyethylenimine is prepared by the reaction of a polyethylenimine with propyleneoxide. The polyethylenimines are generally available under the LUPASOL trade name from BASF Corporation (Rensselaer, New York) or from Aldrich (Milwaukee, Wisconsin).

Exemplary propylenimine compounds include, without limitation, polypropylenimine tetraamine dendrimer (N.N.N',N',-tetrakis(3-aminopropyl)-1,4-butanediamine), polypropylenimine octaamine dendrimer (4,17-bis(3-aminopropyl)-8,13-bis[3-[bis(3-aminopropyl)-amino]propyl]-4,8,13,17-tetraazaeicosane-1,20-diamine), polypropylenimine hexadecaamine dendrimer, polypropylenimine dotricontaamine dendrimer, and polypropylenimine tetrahexacontaamine dendrimer.

Amine-containing compounds having a wide range of molecular weights may be advantageously used in the present invention. In general, the polymeric amines have a number average molecular weight of ≥ 400 Daltons. Exemplary polymeric amines are those having a number average molecular weight of from 400 to 2,000,000, although polymeric amines having either higher or lower number average molecular weights may be used. Another exemplary range of number average molecular weights is from 500 to 500,000 Daltons. The polymeric amines may be linear or branched.

In general, the amine-containing compound is used in an amount sufficient to complex the copper ion in solution such that precipitation of the copper ion is reduced or eliminated. Typically, the amine-containing compound is present in an amount sufficient to provide at least one mole equivalent of complexing moiety per mole of copper ion. It will be appreciated by those skilled in the art that a polymeric amine may contain one or a number of complexing moieties, such as amino groups. For example, 0.5 moles of an amine-containing compound having two complexing moieties (amino groups capable of complexing copper) provides the equivalent of 1 mole of complexing moieties. Likewise, 1 mole of an amine-containing compound having 4 complexing moieties provides the equivalent of 4 moles of complexing moieties. It will be appreciated by those skilled in the art that as the molecular weight of the polymeric amine increases, fewer of the complexing moieties may be available for complexing copper ions as large polymers may coil or fold on itself. In general, the amine-containing compound is present in an amount sufficient to provide a copper ion to complexing moiety (amino group) ratio of from 1:1 to 1:100, although ratios above and below this range may be used. Exemplary copper to complexing moiety ratios are from 1:1 to 50, from 1:1 to 1:20, from 1:1 to 1:10, and from 1:2 to 1: 10.

The present copper electroplating bath may optionally contain one or more additional components, such as, but not limited to, bath stabilizing agents, buffering agents, surfactants, additional complexing agents, additional leveling agents, halides and brighteners. Such electroplating bath is typically free of a reducing agent for copper. Bath stabilizing agents are used to extend shelf life of the plating bath components, to prolong bath life during use, or both. Any suitable bath stabilizing agent may be used, the selection of which is well within the ability of those skilled in the art. Any suitable buffering agent may be used. Boric acid is an exemplary buffering agent. If used, the boric acid may be present in a concentration of from 0.01 to 0.5 M.

Exemplary surfactants useful in the present compositions are polymeric materials, preferably having heteroatom substitution, particularly oxygen linkages. In particular, the surfactants are high molecular weight polyethers, such as those of the following formula:

R - O -(CXYCX'Y'O)ₙH

where R is an aryl or alkyl group containing from about 2 to 20 carbon atoms; each X, Y, X' and Y' is independently hydrogen, alkyl such as methyl, ethyl and propyl, aryl such as phenyl; aralkyl such as benzyl; and preferably one or more of X, Y, X' and Y' is hydrogen; and n is an integer between 5 and 100,000. Such polymers are available commercially, such as from BASF (sold by BASF under TETRONIC and PLURONIC tradenames), and Chemax.

In one embodiment, the surfactant is a compound capable of providing a copper filled, sub-micron sized aperture free of pits and voids. Such surfactants include, without limitation, poly(alkylene oxide) random copolymers including as polymerized units two or more alkylene oxide monomers. Mixtures of such surfactants may be used. By "random copolymer" it is meant a copolymer having its repeat units randomly distributed along the copolymer chain. A wide variety of alkylene oxide monomers may be used, such as, but not limited to, ethylene oxide, propylene oxide, butylene oxide, and styrene oxide. Typically, the poly(alkylene oxide) random copolymer is an ethylene oxide ("EO") / propylene oxide ("PO") random copolymer. Exemplary EO/PO random copolymers are those having the formula HO-(A)ₙ-(B)ₘ-H wherein each of A and B are selected from ethyleneoxy and propyleneoxy groups provided that A and B are different; and n and m are the number of A and B repeat units, respectively, in the copolymer. "Ethyleneoxy" refers to moieties having the formula -(CH₂-CH₂-O)-. "Propyleneoxy" refers to moieties having the formula -(CH(CH₃)-CH₂-O)- or -(O-CH(CH₃)-CH₂)-. Typically, n is in the range of 1 to 250 and specifically 10 to 170. Such poly(alkylene oxide) random copolymers may be linear or star-shaped copolymers. Such star copolymers are poly(alkylene oxide) random copolymers having 3 or more terminal hydroxyl groups. In general, each arm of the star shape terminates in a hydroxyl group. Typically, such star random copolymers have 3 or 4 terminal hydroxyl groups, although copolymers having a greater number of terminal hydroxyl groups may be employed.

Any halide may optionally be used in the present plating baths. Exemplary halides being chloride and bromide. A wide range of halide ion concentrations (if a halide ion is employed) may be suitably utilized, e.g. from about 0 (where no halide ion employed) to 100 ppm of halide ion in the plating solution, and more typically from 0 to 75 ppm. Such halides may be added as the corresponding hydrogen halide acid or as any suitable salt.

A wide variety of brighteners may be employed in the present electroplating compositions. Typical brighteners contain one or more sulfur atoms, and typically without any nitrogen atoms and a molecular weight of 1000 or less. Brightener compounds that have sulfide and/or sulfonic acid groups are generally preferred, particularly compounds that comprise a group of the formula R'-S-R-SO₃X, where R is an optionally substituted alkyl (which include cycloalkyl), optionally substituted heteroalkyl, optionally substituted aryl group, or optionally substituted heteroalicyclic; X is a counter ion such as sodium or potassium; and R' is hydrogen or a chemical bond (i.e. -S-R-SO₃X or substituent of a larger compound). Typically alkyl groups will have from one to 16 carbons, more typically one to 8 or 12 carbons. Heteroalkyl groups will have one or more hetero (N, O or S) atoms in the chain, and preferably have from 1 to about 16 carbons, more typically 1 to 8 or 12 carbons. Carbocyclic aryl groups are typical aryl groups, such as phenyl and naphthyl. Heteroaromatic groups also will be suitable aryl groups, and typically contain 1 to 3 N, O or S atoms and 1-3 separate or fused rings and include e.g. coumarinyl, quinolinyl, pyridyl, pyrazinyl, pyrimidyl, furyl, pyrrolyl, thienyl, thiazolyl, oxazolyl, oxidizolyl, triazole, imidazolyl, indolyl, benzofuranyl, benzothiazol, and the like. Heteroalicyclic groups typically will have 1 to 3 N, O or S atoms and from 1 to 3 separate or fused rings and include e.g. tetrahydrofuranyl, thienyl, tetrahydropyranyl, piperdinyl, morpholino, pyrrolindinyl, and the like. Substituents of substituted alkyl, heteroalkyl, aryl or heteroalicyclic groups include, without limitation, C₁₋₈ alkoxy, C₁₋₈ alkyl, halogen, cyano, and nitro.

Copper plating baths according to the present invention may be prepared by combining the one or more sources of copper ion, the one or more amine-containing compounds, water and the one or more optional additives in any order. The baths may be used at a wide variety of temperatures, such as below room temperature, at room temperature or above room temperature. Exemplary temperature ranges include, but are not limited to, 20° to 90° C. Other exemplary temperatures are from 20° to 70° C and from 20° to 50° C.

A layer of copper can be deposited directly on a barrier layer according to the present invention. Such copper layer can be thin deposit, such as up to 2000 Å, or a thick deposit, such as > 2000 Å. Thin copper deposits, such as in the range of 5 to 2000 Å or even from 50 to 1500 Å are particularly suitable for use as metal seed layers. Such seed layers provide a sufficiently conductive layer for subsequent electroplating.

Copper seed layers are deposited by contacting a substrate containing one or more barrier layers with a plating bath of the present invention. Such contact may be by immersion of the substrate in the plating bath or by spraying the plating bath on the substrate. In one embodiment, when the substrate is immersed in the plating bath, the bath is agitated. Such agitation may be performed by impingement, air sparging, or by substrate agitation. Sufficient current density is then applied to deposit a desired layer of copper. Exemplary current densities include, without limitation, 0.1 to 25 mA/cm², although higher and lower current densities may also be used. Other exemplary current densities are from 1 to 10 mA/cm² and from 1 to 8 mA/cm². After the desired thickness of copper is deposited, the substrate may be removed from the plating bath, optionally rinsed such as with DI water, and optionally dried.

An advantage of the present copper plating compositions is that they deposit a copper seed layer on a barrier layer faster than conventional copper plating baths containing ethylenediamine as the chelating agent. In general, seed layers can be deposited according to the present invention in ≤ 300 seconds. Exemplary plating times are from 0.1 to 180 seconds, from 1 to 150 seconds, and from 10 to 120 seconds. For example, 500 Å thick copper layer can be deposited on tungsten or tungsten nitride in ≤ 30 seconds. A 1000 Å thick copper layer can be deposited on tungsten or tungsten nitride in ≤ 60 seconds.

Thus, the present invention provides a method of depositing a copper seed layer including the steps of contacting a substrate including a barrier layer with an electroplating bath including one or more sources of copper ion, one or more amine-containing compounds chosen from alkanolamines, polymeric amines and mixtures thereof, and water; and applying sufficient current density for a period of time to deposit a desired layer of copper.

In another embodiment, the present copper plating baths may be used to repair or enhance a discontinuous seed layer. Seed layers deposited by non-electrochemical techniques, such as by PVD, may suffer from discontinuities (or voids). Such discontinuities need to be repaired (or enhanced) in order to provide a uniform conductive layer on the substrate. Such discontinuous seed layers can be easily repaired according to the present invention. Thus, the present invention provides a method of providing a metal seed layer substantially free of discontinuities disposed on a substrate including the steps of contacting a discontinuous metal seed layer disposed on the substrate with an electroplating bath including one or more sources of copper ions, one or more amine-containing compounds chosen from alkanolamines, polymeric amines and mixtures thereof, and water; and applying sufficient current density for a period of time to repair the discontinuous seed layer. While not intending to be bound by theory, it is believed that the present electroplating baths deposit copper in a substantially lateral 2-dimensional manner inside features which provides for smooth deposits, such that discontinuities or voids in the seed layer are filled in or repaired preferentially to depositing copper within the apertures. By "substantially free of discontinuities" it is meant a metal seed layer where only a small number of discontinuities is present in the seed layer, typically such discontinuities total less than 5% of the total surface area, more typically ≤ 3%, and still more typically ≤ 1%. In one embodiment, the metal seed layer is free of discontinuities. The term "repair the discontinuities" refers to reducing the number of discontinuities in a discontinuous seed layer, as compared to the same seed layer before such repair. After the seed layer is repaired, the substrate may be removed from the plating bath, optionally rinsed such as with DI water, and optionally dried.

Also provided by the present invention is a method of manufacturing an electronic device, particularly an integrated circuit, including the step of depositing a copper seed layer including the steps of contacting a substrate including a barrier layer with an electroplating bath including one or more sources of copper ion, one or more amine-containing compounds chosen from alkanolamines, polymeric amines and mixtures thereof, and water; and applying sufficient current density for a period of time to deposit a desired seed layer of copper.

It will be appreciated by those skilled in the art that once a copper seed layer has been deposited or a metal seed layer has been repaired according to the present invention, the substrate may then be subjected to electrochemical plating of a final metal layer. Such electrochemical plating may be by any known means. In the alternative, the substrate may then be subjected to electroless plating of the final metal layer. Such electroless plating may be by any known means. The final metal layer may be any suitable metal, such as copper, silver, nickel, gold, or any alloy of any of these. In one embodiment, the final metal layer is copper. Such copper final metal layer may be deposited using any known copper plating bath. One suitable bath is sold under the ULTRAFILL tradename by Shipley Company (Marlborough, Massachusetts).

After the final metal layer is deposited, an encapsulating layer may optionally be deposited. This layer serves to prevent diffusion or migration of copper or other deposited metals into dielectric layers that may be subsequently deposited on top of the final metal layer. Encapsulating layers include, without limitation, one or more of cobalt or cobalt alloys with one or more other elements such as tungsten, phosphorus, and boron. Cobalt-tungsten phosphorus and cobalt-tungsten-boron are examples.

While the present copper plating baths have been described above for the deposition of and repair of seed layers, it will be appreciated by those skilled in the art that the present compositions may also be used in the plating of copper layers on a variety of substrates including the electronic devices described above as well as for decorative plating such as in plating object d'art.

The following examples are expected to illustrate various aspects of the present invention, but are not intended to limit the scope of the invention.

### Example 1

A copper electroplating bath is prepared by combining copper sulfate in an amount to provide a copper ion concentration of 0.04 M (2.54 g/L), a polyethylenimine compound having a calculated number average molecular weight ("Mn") of 1800 and a viscosity ("η", measured at 25°C) of 5000 - 35,000 cps (LUPASOL PR 8515, from BASF Corporation) (8 g/L, 0.186 M with respect to primary and secondary amine groups), boric acid (3.1 g/L, 0.05 M) and 1 L of DI water. The ratio of copper ion to polyethylenimine is approximately 1:3. The pH of the bath is adjusted by adding sufficient tetramethylammonium hydroxide to provide a pH of 11.5. The temperature of the bath is set to 25° C.

### Example 2 (Comparative)

The procedure of Example 1 is repeated except that the polyethylenimine compound is replaced with ethylene diamine (5.35 mL/L). The copper ion to amine ratio is 1:1.9 by weight.

### Example 3

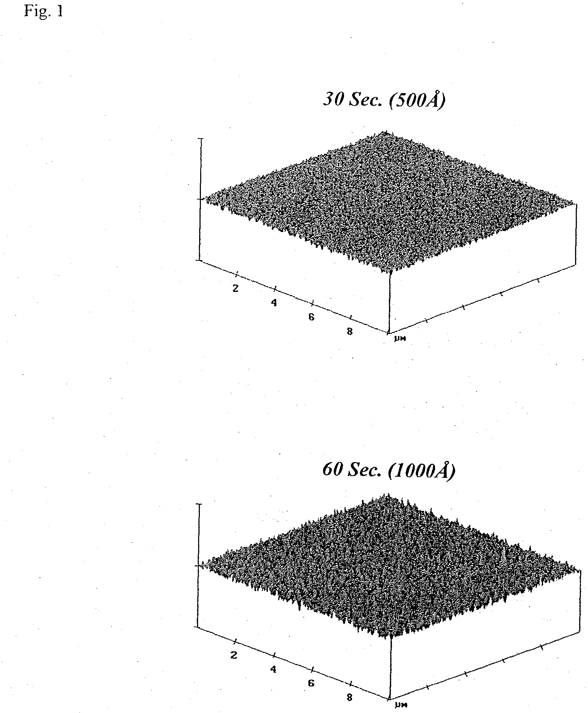

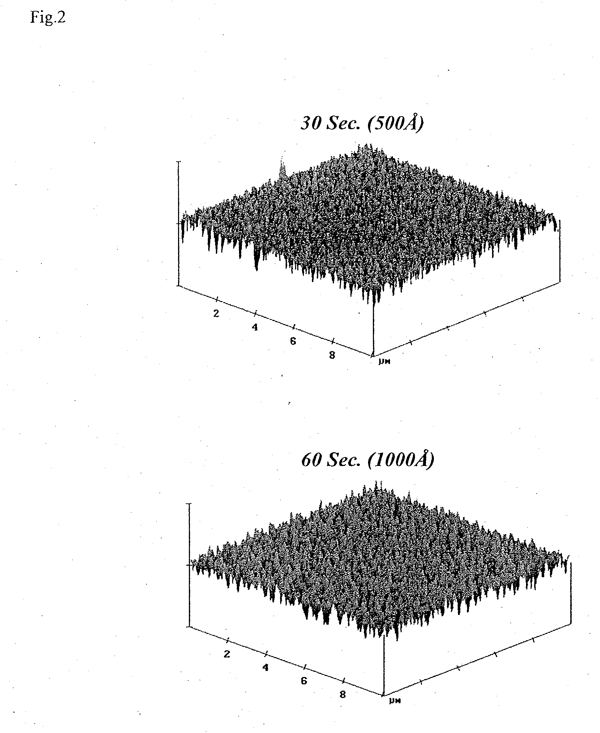

Samples of a commercial test wafer containing a tungsten barrier layer on a dielectric layer are immersed in the plating bath of either Example 1 or 2. Current is applied to the plating bath at a current density of 2-5 mA/cm². A copper seed layer having a thickness of 200-500 Å is obtained. The wafer samples are then removed from the bath and rinsed with DI water. After drying, the wafer samples are analyzed by atomic force microscopy. Fig. 1 shows an AFM of the surface of the copper layer deposited using the bath of Example 1. Fig. 2 shows an AFM of the surface of the copper layer deposited using the bath of Example 2. Atomic force microscopy is also used to determine the root mean square roughness ("Rs"), arithmetic average roughness ("Ra") and height differential ("Z"). These results are reported in Table 1

**Table 1**

| Plating Bath | Plating Time (sec.) | Ra (nm) | Rs (nm) | Z (nm) |
|---|---|---|---|---|
| Example 1 (Invention) | 30 | 2.4 | 3.1 | 37 |
| " | 60 | 3.5 | 4.6 | 84 |
| Example 2 (Comparative) | 30 | 9.7 | 12.5 | 171 |
| " | 60 | 106 | 13.8 | 116 |

The lower the values of Ra and Rs are, the smoother the surface is. Lower values of Z indicate a more uniform surface height across the evaluated area. Thus, layers of copper having low Ra, Rs and Z-values are desired. As can be seen from the above data, the copper layers deposited from the bath of the invention show a 75% or greater reduction in average surface roughness as compared to the copper layers deposited from the Comparative plating bath. For a given plating time, the present plating baths provide smoother surfaces than those obtained from conventional copper baths.

### Example 4

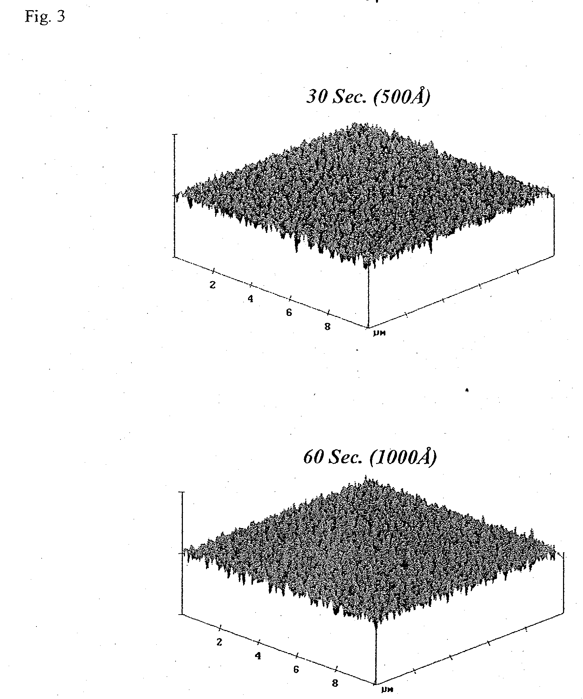

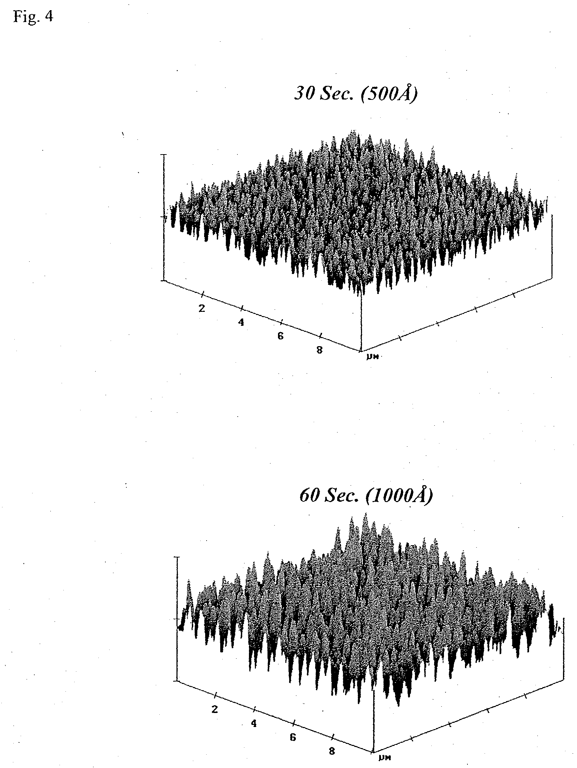

The procedure of Example 3 is repeated except that the wafers contained a tungsten nitride layer instead of a tungsten layer. Fig. 3 shows an AFM of the surface of the copper layer deposited using the bath of Example 1. Fig. 4 shows an AFM of the surface of the copper layer deposited using the bath of Example 2. The roughness and height differential results are reported in Table 2.

**Table 2**

| Plating Bath | Plating Time (sec.) | Ra (nm) | Rs (nm) | Z (nm) |
|---|---|---|---|---|
| Example 1 (Invention) | 30 | 5.7 | 7.2 | 71 |
| " | 60 | 6.0 | 7.5 | 77 |
| Example 2 (Comparative) | 30 | 16.0 | 18.8 | 115 |
| " | 60 | 25.5 | 31.0 | 181 |

As can be seen from the above data, the copper layers deposited from the bath of the invention show a 65% or greater reduction in average surface roughness as compared to the copper layers deposited from the Comparative plating bath. For a given plating time, the present plating baths provide smoother surfaces than those obtained from conventional copper baths.

### Example 5

A wafer containing a tungsten barrier layer and having vias is contacted with the plating bath of Example 1 for 30 sec. The wafer is then removed from the bath, rinsed and then dried. The wafer is then evaluated by scanning electron microscopy. A uniform thin layer of copper is obtained across the barrier layer and inside the vias.

### Examples 6-15

Example 1 is repeated except that the components and their amounts are varied. The formulations prepared are reported in Table 3.

**Table 3**

| Example | Copper Salt / Copper Ion Concentration | Amine-containing Compound | Copper Ion : Amino Group Ratio | Optional Additives | pH |
|---|---|---|---|---|---|
| 6 | Copper sulfate / 0.02 M | Polyethylenimine (Mn = 1800, η = 250-650 cps) | 1:2 | Boric acid | 11.5 |
| 7 | Copper sulfate / 0.05 M | Polyethylenimine (Mw = 2,000,000*, η = 500-1000 cps) | 1:4 | - | 10 |
| 8 | Copper sulfate / 0.1 M | Polyethylenimine (Mn = 60,000, η = 130-450 cps) | 1:5 | Boric acid | 9 |
| 9 | Copper methanesulfonate / 0.2 M | Polyethylenimine (η = 130-450 cps) | 1: 4 | Boric acid | 8.5 |
| 10 | Copper methanesulfonate / 0.06 M | Polypropylenimine octaamine dendrimer | 1 : 6 | - | 10.5 |
| 11 | Copper sulfate / 0.04 M | Ethoxylated polyethylenimine (Mn = 110,000, η = <2500 cps) | 1 : 8 | - | 9.5 |
| 12 | Copper sulfate / 0.04 M | Polyethylenimine-epichlorohydrin (Mn = 5000, η = 10-100 cps) | 1: 3 | Boric acid | 7.5 |
| 13 | Copper sulfate / 0.04 M | Polyethylenimine (Mn = 1800, η = 5000-35,000 cps) | 1: 2 | Boric acid | 6 |
| 14 | Copper sulfate / 0.03 M | Polypropylenimine octaamine dendrimer | 1 : 7 | Boric acid | 9 |
| 15 | Copper methanesulfonate / 0.08 M | Polypropylenimine hexadecaamine dendrimer | 1: 10 | - | 12 |

| | | | | | |
|---|---|---|---|---|---|
| * Molecular weight ("Mw") determined by light scattering | | | | | |

The above plating baths are expected to deposit a smooth, uniform layer of copper on tungsten and tungsten nitride barrier layers.

### Example 16

The procedure of Example 1 is repeated to prepare a number of electroplating baths having pH values of 9, 9.5, 10, 10,5, and 11.

## Claims

1. A composition suitable for depositing a copper seed layer comprising one or more sources of copper ions; one or more amine-containing compounds chosen from alkanolamines, polymeric amines and mixtures thereof; and water, wherein the composition has a pH > 7.

2. The composition of claim 1 wherein at least one polymeric amine has a weight average molecular weight of ≥ 400 Daltons.

3. The composition of claim 1 wherein the composition comprises copper as the only metal to be deposited.

4. A method of depositing a copper seed layer on a substrate comprising a barrier layer comprising the steps of contacting the substrate with an electroplating bath comprising one or more sources of copper ion, one or more amine-containing compounds chosen from alkanolamines, polymeric amines and mixtures thereof, and water; and applying sufficient current density for a period of time to deposit a desired seed layer of copper.

5. The method of claim 4 wherein at least one polymeric amine has a weight average molecular weight of ≥ 400 Daltons.

6. A method of repairing a seed layer on a substrate, the seed layer having discontinuities, comprising the steps of contacting the substrate with the an electroplating bath comprising one or more sources of copper ion, one or more amine-containing compounds chosen from alkanolamines, polymeric amines and mixtures thereof, and water and applying sufficient current density for a period of time to deposit a repair the discontinuities.

7. The method of claim 6 wherein at least one polymeric amine has a weight average molecular weight of ≥ 400 Daltons.

8. A method of manufacturing an electronic device including the step of depositing a copper seed layer including the steps of contacting a substrate including a barrier layer with an electroplating bath including one or more sources of copper ion, one or more amine-containing compounds chosen from alkanolamines, polymeric amines and mixtures thereof, and water; and applying sufficient current density for a period of time to deposit a desired seed layer of copper.

9. The method of claim 8 wherein the electronic device is an integrated circuit.

10. The method of claim 8 wherein the substrate comprises one or more apertures having a size of ≤ 1µm.
